# EUROPEAN PATENT APPLICATION

(11) **EP 2 306 521 A2**
(43) Date of publication of application: **06.04.2011**
(21) Application number: 09762671.7
(22) Date of filing: 10.06.2009
(51) Int. Cl.: H01L 27/146

(54) **METHOD FOR MANUFACTURING CMOS IMAGE SENSORS USING A DOUBLE HARD MASK COATING**

(30) Priority: 11.06.2008 KR 20080054879
(71) Applicant: Crosstek Capital, LLC, Wilmington, DE 19808 (US)
(72) Inventor: BACK, Woon-Suck, Cheongju-si Chungcheongbuk-do 361-271 (KR)
(74) Representative: Kazi, Ilya
(86) International application number: PCT/KR2009/003131
(87) International publication number: WO 2009/151284

(57) **Abstract**

Disclosed is a method of manufacturing a CMOS image sensor, capable of forming silicide in a logic region and facilitating ion implantation into a pixel region while keeping a hard mask layer in a thin thickness without performing a process for removing the hard mask layer. The critical dimension is easily controlled when forming a gate pattern and the uniformity in the critical dimension of a gate photoresist pattern is improved. The method includes the steps of forming a gate conductive layer on a substrate on which a pixel region and a logic region are defined; forming a hard mask pattern on the gate conductive layer in such a manner that a thickness of the hard mask pattern in the pixel region is thicker than a thickness of the hard mask pattern in the logic region; forming a gate pattern in the pixel region and the logic region by etching the gate conductive layer using the hard mask pattern as an etching barrier; removing the hard mask pattern remaining in the logic region; and forming silicide in the logic region.

## Description

### Technical Field

The present invention relates to a method of manufacturing a semiconductor device. More particularly, the present invention relates to a method of manufacturing a CMOS image sensor using a double hard mask layer.

### Background art

Among semiconductor devices, a CMOS image sensor is manufactured through a CMOS process and a unit pixel of the CMOS sensor includes one photodiode and three or four transistors for driving the unit pixel. Similar to transistors of general memory devices, the transistors of the CMOS image sensor may include a gate electrode and source/drain regions.

When the ion implantation process is performed to form the photodiode of the CMOS image sensor, a thick hard mask is formed on an entire surface of a substrate as an ion implantation blocking material, and an inorganic anti-reflective layer including silicon oxynitride (SiON) is formed over the thick hard mask as an anti-reflective layer.

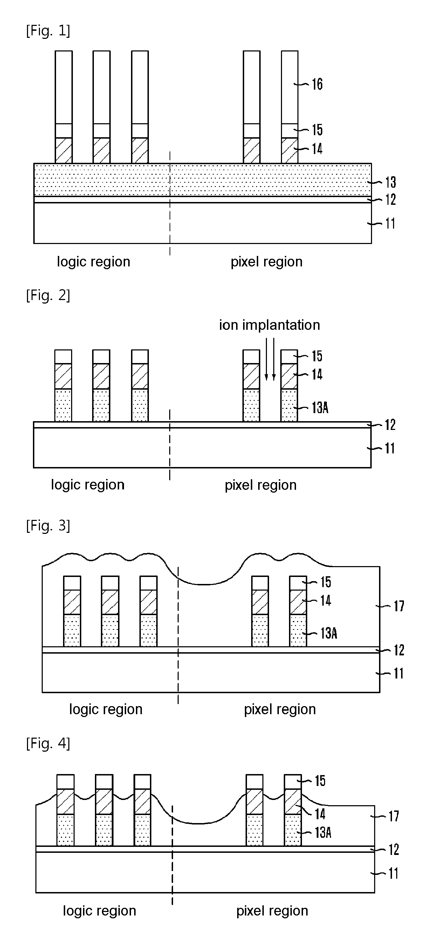

FIGS. 1 to 6 are sectional views showing a method of manufacturing a CMOS image sensor according to the related art.

As shown in FIG. 1, a gate insulating layer 12 is formed on a semiconductor substrate 11 on which a pixel region and a logic region are defined and a gate polysilicon layer 13 is formed on the gate insulating layer 12.

Then, a hard mask layer 14 is formed on the gate polysilicon layer 13 and an anti-reflective layer 15 is formed on the hard mask layer 15. The anti-reflective layer 15 is an inorganic anti-reflective layer including silicon oxynitride (SiON).

Thereafter, a photoresist is coated on the anti-reflective layer 15 and a first photoresist pattern 16 is formed by patterning the photoresist through the exposure and development process.

Then, the anti-reflective layer 15 and the hard mask layer 14 are etched using the first photoresist pattern 16 as an etching barrier.

Then, as shown in FIG. 2, after the first photoresist pattern 16 has been removed, the gate polysilicon layer 13 is etched using the hard mask layer 14 as an etching barrier, thereby forming a gate pattern 13A.

After that, the ion implantation process is performed to form the photodiode.

Then, as shown in FIG. 3, a photo process is performed using a reverse mask to form silicide. Thus, a second photoresist pattern 17 is formed.

Next, as shown in FIG. 4, the second photoresist pattern 17 is selectively removed on the gate pattern 13A, so that the anti-reflective layer 15 is exposed.

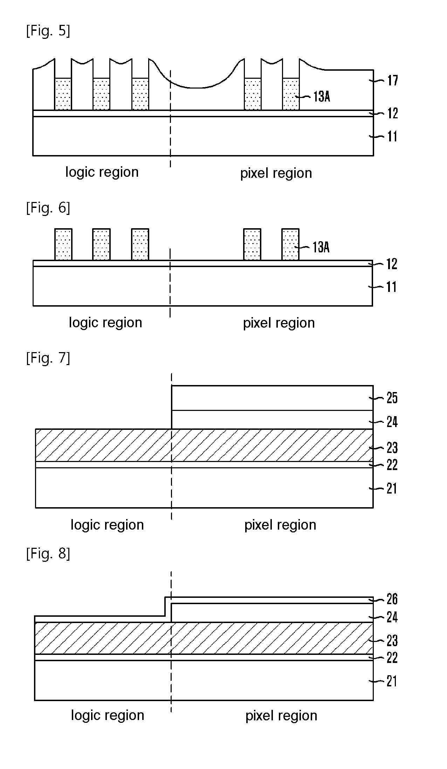

Then, as shown in FIG. 5, the anti-reflective layer 15 and the hard mask layer 14 are removed through the wet etching process.

In addition, as shown in FIG. 6, the ashing and cleaning processes are performed after the silicide process, thereby completely removing the second photoresist pattern 17.

However, according to the related art, the hard mask layer 14 is too thick, so the critical dimension may not be easily controlled when the gate pattern 13A is formed. In addition, since the inorganic anti-reflective layer is used as the anti-reflective layer, the uniformity of the critical dimension of the first photoresist pattern 16 may be diminished.

In addition, according to the related art, the residual hard mask layer must be removed to form the silicide, so the process may be complicated.

### Detailed description of the invention

### Technical problem

Accordingly, the present invention has been made to solve the above-mentioned problems occurring in the prior art, and the present invention provides a method of manufacturing a CMOS image sensor, capable of forming silicide in a logic region and facilitating ion implantation into a pixel region while keeping a hard mask layer at a thin thickness without performing a process for removing the hard mask layer.

### Technical Solution

In addition, the present invention provides a method of manufacturing a CMOS image sensor, capable of easily controlling the critical dimension when forming a gate pattern while improving the uniformity of the critical dimension of a gate photoresist pattern.

In accordance with an aspect of the present invention, there is provided a method of manufacturing a CMOS image sensor, the method including the steps of: forming a gate conductive layer on a substrate on which a pixel region and a logic region are defined; forming a hard mask pattern on the gate conductive layer in such a manner that a thickness of the hard mask pattern in the pixel region is thicker than a thickness of the hard mask pattern in the logic region; forming a gate pattern in the pixel region and the logic region by etching the gate conductive layer using the hard mask pattern as an etching barrier; removing the hard mask pattern remaining in the logic region; and forming silicide in the logic region.

In accordance with another aspect of the present invention, there is provided a method of manufacturing a CMOS image sensor, the method including the steps of: forming a gate conductive layer on a substrate on which a pixel region and a logic region are defined; forming a hard mask layer on the gate conductive layer in such a manner that a thickness of the hard mask layer in the pixel region is thicker than a thickness of the hard mask layer in the logic region; forming an organic anti-reflective layer on the hard mask layer; forming a first photoresist pattern on the organic anti-reflective layer; etching the organic anti-reflective layer and the hard mask layer using the first photoresist pattern as an etching barrier; forming a gate pattern in the pixel region and the logic region by etching the gate conductive layer using the hard mask layer as an etching barrier; removing the hard mask layer remaining in the logic region; and forming silicide in the logic region.

### Advantageous Effects

According to the present invention, a thickness of the hard mask layer in the pixel region, into which the ions are implanted to form the photodiode, is different from a thickness of the hard mask layer in the logic region, into which the ions are not implanted, so that the process for removing the hard mask layer is not necessary. In addition, the hard mask layer has a thin thickness, so the critical dimension can be easily controlled when the gate pattern is formed. Further, since the organic anti-reflective layer is used as the anti-reflective layer, the uniformity of the critical dimension of the photoresist pattern can be improved.

In addition, since the reverse mask is not required, the hard mask layer may not remain in the gate pattern, so that various patterns can be utilized.

Further, the mask can be manufactured at a low cost as compared with the cost for the reverse mask, and the process for removing the hard mask layer can be omitted, so that the manufacturing cost and manufacturing time for the semiconductor device can be reduced.

In addition, according to the present invention, the thickness of the hard mask layer is reduced, the organic anti-reflective layer is used as the anti-reflective layer, and the process for removing the hard mask layer is omitted, so that the critical dimension of the gate pattern can be stably maintained, thereby improving the reliability and product yield of the semiconductor devices.

### Description of Drawings

The above and other objects, features and advantages of the present invention will be more apparent from the following detailed description taken in conjunction with the accompanying drawings, in which:
FIGS. 1 to 6 are sectional views showing a method of manufacturing a CMOS image sensor according to the related art; and
FIGS. 7 to 14 are sectional views showing a method of manufacturing a CMOS image sensor according to the exemplary embodiment of the present invention.

### Mode For Invention

Hereinafter, exemplary embodiments of the present invention will be described in detail with reference to the accompanying drawings.

FIGS. 7 to 14 are sectional views showing a method of manufacturing a CMOS image sensor according to an exemplary embodiment of the present invention.

As shown in FIG. 7, a gate insulating layer 22 is formed on a semiconductor substrate 21. The gate insulating layer 22 can be formed by oxidizing a surface of the semiconductor substrate 21. A pixel region for a photodiode and a logic region for transistors are defined on the semiconductor substrate 21.

Then, a gate conductive layer 23 is deposited on the gate insulting layer 22. The gate conductive layer 23 may include a doped polysilicon layer or an undoped polysilicon layer.

After that, a first hard mask layer 24 including an oxide-based material is deposited on the gate conductive layer 23. The first hard mask layer 24 may include an oxide layer. Preferably, the first hard mask layer 24 includes TEOS (tetraethyl ortho silicate) formed through an LPCVD (low pressure chemical vapor deposition), which is referred to as LPTEOS. The first hard mask layer 24 may have a thickness of about 500Å to 1500Å.

Then, the photoresist is coated on the first hard mask layer 24, and a first photoresist pattern 25 is formed by patterning the photoresist through the exposure and development process. At this time, the first photoresist pattern 25 covers the pixel region and exposes the logic region.

After that, the first hard mask layer 24 is removed in the logic region which is exposed through the first photoresist pattern 25, by performing the wet etching process. Therefore, the first hard mask layer 24 may remain only in the pixel region. Preferably, since the first hard mask layer 24 is an oxide layer, the wet etching process is performed using the solution mixed with HF (hydrofluoric) acid. For instance, the wet etching process is performed using the BOE (buffered oxide etchant) solution.

Then, as shown in FIG. 8, the first photoresist pattern 25 is removed and a second hard mask layer 26 is formed over an entire surface of the resultant structure. A thickness of the second hard mask layer 26 is equal to or smaller than the thickness of the first hard mask layer 24. Preferably, the second hard mask layer 26 is thinner than the first hard mask layer 24. Preferably, the second hard mask layer 26 includes TEOS (tetraethyl ortho silicate) formed through an LPCVD (low pressure chemical vapor deposition), which is referred to as LPTEOS. The second hard mask layer 26 may have a thickness of about 500Å to 1000Å.

Due to the second hard mask layer 26, a dual hard mask layer structure is formed in the pixel and logic regions. Specifically, a stack structure of the first and second hard mask layers 24 and 26 is formed in the pixel region, and the second hard mask layer 26 is formed in the logic region. Thus, the thickness of the hard mask layer in the pixel region is different from the thickness of the hard mask layer in the logic region. That is, the hard mask layer in the pixel region is thicker than the hard mask layer in the logic region, so that the dual hard mask layer structure is formed.

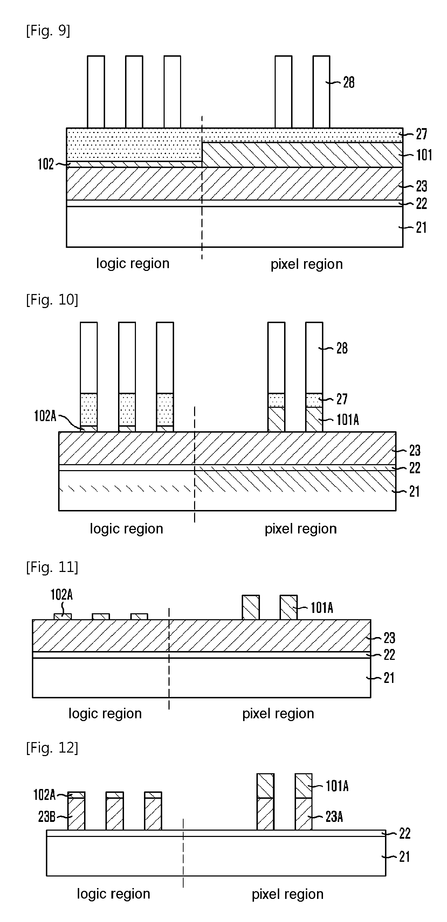

Then, as shown in FIG. 9, an anti-reflective layer 27 is formed on the entire surface of the resultant structure. The hard mask layer formed in the pixel region will be referred to as a thick hard mask 101, and the hard mask layer formed in the logic region will be referred to as a thin hard mask 102. The thick hard mask 101 includes the stack structure of the first and second hard layers 24 and 26, and the thin hard mask includes only the second hard mask layer 26. For the purpose of convenience, the following description will be focused on the thick hard mask 101 and the thin hard mask 102 and reference numerals of the first and second hard mask layers will be omitted.

The anti-reflective layer 27 may include an organic anti-reflective layer. The organic anti-reflective layer represents superior anti-reflective characteristics as compared with the inorganic anti-reflective layer, such as the SiON layer, so that the critical dimension of the photoresist pattern may be reliably established in the subsequent photo process, so that the uniformity of the critical dimension of the photoresist pattern can be improved. The organic anti-reflective layer may include a material containing C, H and O, similar to the photoresist.

After that, the photoresist is coated on the resultant structure and a second photoresist pattern 28 is formed by patterning the photoresist through the exposure and development process. The second photoresist pattern 28 is a gate photoresist pattern to simultaneously form the gate pattern in the pixel region and the logic region.

Then, as shown in FIG. 10, the anti-reflective layer 27 is etched using the second photoresist pattern 28 as an etching barrier. In addition, the thick hard mask 101 and the thin hard mask 102 are simultaneously etched through the plasma dry etching process.

The anti-reflective layer 27 is etched using oxygen-based gas and the thick hard mask 101 and the thin hard mask 102 are etched using fluorine-based gas. The oxygen-based gas used for etching the anti-reflective layer 27 may include oxygen gas (O₂) mixed with one selected from the group consisting of N₂, HBr, CF₄ and Cl₂. For instance, the oxygen-based gas includes the mixture gas, such as O₂/N₂, O₂/HBr, O₂/CF₄, or O₂/Cl₂. The fluorine-based gas used for etching the hard masks including the oxide layers may include one selected from the group consisting of CF₄, CHF₃, C₂F₆ and CH₂F₂.

As the thick hard mask 101 and the thin hard mask 102 have been etched, a thick hard mask pattern 101A is formed in the pixel region and a thin hard mask pattern 102A is formed in the logic region. The thick hard mask pattern 101A formed in the pixel region is thicker than the thin hard mask pattern 102A formed in the logic region.

Then, as shown in FIG. 11, the second photoresist pattern 28 and the anti-reflective layer 27 are removed.

After that, as shown in FIG. 12, the gate conductive layer 23 is etched using the thick hard mask pattern 101A and the thin hard mask pattern 102A as an etching barrier, thereby forming gate patterns 23A and 23B. At this time, since the gate conductive layer 23 is a polysilicon layer, the gate conductive layer 23 is etched using the mixture gas including HBr, Cl₂ and HeO₂. The gate patterns 23A and 23B are simultaneously formed in the pixel region and the logic region.

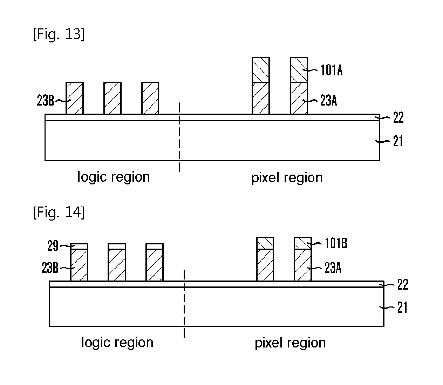

Then, as shown in FIG. 13, the thin hard mask pattern 102A remaining in the logic region is removed by performing the wet etching process using the HF solution. The reason for removing the thin hard mask pattern 102A remaining in the logic region is to form silicide from the gate pattern 23 formed in the logic region. Since the thin hard mask pattern 102A includes the oxide material, the silicide can be selectively removed from the gate pattern 23 through the wet etching process using the HF solution without attack to the gate pattern 23. The thick hard mask pattern 102B may be partially etched when the thin hard mask pattern 102A is removed, but the thick hard mask pattern 102B may remain with a certain thickness. Reference numeral 101B indicates the remaining thick hard mask pattern.

Next, as shown in FIG. 14, silicide 29 is formed in the logic region. The silicide 29 is formed only on the gate pattern 23B.

As described above, according to the embodiment of the present invention, the silicide is not formed on the gate pattern 23A formed in the pixel region, into which ions are implanted to form the photodiode, so the hard mask layer may remain on the gate pattern 23A. In addition, since the logic region is not the ion implantation region to form the photodiode, the thick hard mask layer is not needed for the gate pattern 23A.

Therefore, since the thickness of the hard mask layer in the pixel region, into which the ions are implanted to form the photodiode, is different from the thickness of the hard mask layer in the logic region, into which the ions are not implanted, the process for removing the hard mask layer is not required. Further, the hard mask layer is kept with the thin thickness, so that the critical dimension can be easily controlled when the gate pattern is formed. In addition, since the organic anti-reflective layer is used as the anti-reflective layer, the uniformity in the critical dimension of the photoresist pattern can be improved.

Although an exemplary embodiment of the present invention has been described for illustrative purposes, those skilled in the art will appreciate that various modifications, additions and substitutions are possible, without departing from the scope and spirit of the invention as disclosed in the accompanying claims.

## Claims

1. A method of manufacturing a CMOS image sensor, the method comprising the steps of:
forming a gate conductive layer on a substrate on which a pixel region and a logic region are defined;
forming a hard mask pattern on the gate conductive layer in such a manner that a thickness of the hard mask pattern in the pixel region is thicker than a thickness of the hard mask pattern in the logic region;
forming a gate pattern in the pixel region and the logic region by etching the gate conductive layer using the hard mask pattern as an etching barrier;
removing the hard mask pattern remaining in the logic region; and
forming silicide in the logic region.

2. The method as claimed in claim 1, wherein the step of forming the hard mask pattern includes the steps of:
forming a first hard mask layer on an entire surface of the gate conductive layer;
selectively removing the first hard mask layer in the logic region;
forming a second hard mask layer on an entire surface of a resultant structure including a remaining first hard mask layer in the pixel region; and
simultaneously etching the first and second hard mask layers using a photoresist pattern as an etching barrier.

3. The method as claimed in claim 2, wherein a thickness of the second hard mask layer is thinner than a thickness of the first hard mask layer.

4. The method as claimed in claim 2, wherein the first and second hard mask layers include an oxide layer.

5. The method as claimed in claim 4, wherein the oxide layer includes LPTEOS (low pressure CVD tetraethyl ortho silicate).

6. The method as claimed in claim 2, wherein the first hard mask layer is selectively removed in the logic region by etching the first hard mask layer using a photoresist pattern, which covers the pixel region and exposes the logic region, as an etching barrier.

7. The method as claimed in claim 6, wherein the etching process, which is performed using the photoresist pattern as the etching barrier, includes a wet etching process.

8. The method as claimed in claim 2, wherein the first and second hard mask layers are simultaneously etched through a plasma dry etching process.

9. The method as claimed in claim 1, wherein the hard mask pattern remaining in the logic region is removed through a wet etching process.

10. A method of manufacturing a CMOS image sensor, the method comprising the steps of:
forming a gate conductive layer on a substrate on which a pixel region and a logic region are defined;
forming a hard mask layer on the gate conductive layer in such a manner that a thickness of the hard mask layer in the pixel region is thicker than a thickness of the hard mask layer in the logic region;
forming an organic anti-reflective layer on the hard mask layer;
forming a first photoresist pattern on the organic anti-reflective layer;
etching the organic anti-reflective layer and the hard mask layer using the first photoresist pattern as an etching barrier;
forming a gate pattern in the pixel region and the logic region by etching the gate conductive layer using the hard mask layer as an etching barrier;
removing the hard mask layer remaining in the logic region; and
forming silicide in the logic region.

11. The method as claimed in claim 10, wherein the step of forming the hard mask layer includes the steps of:
forming a first hard mask layer on an entire surface of the gate conductive layer;
selectively removing the first hard mask layer in the logic region; and
forming a second hard mask layer on an entire surface of a resultant structure including a remaining first hard mask layer in the pixel region.

12. The method as claimed in claim 11, wherein a thickness of the second hard mask layer is thinner than a thickness of the first hard mask layer.

13. The method as claimed in claim 12, wherein the first and second hard mask layers include LPTEOS (low pressure CVD tetraethyl ortho silicate).

14. The method as claimed in claim 11, wherein the first hard mask layer is selectively removed in the logic region by etching the first hard mask layer using the second photoresist pattern, which covers the pixel region and exposes the logic region, as an etching barrier.

15. The method as claimed in claim 14, wherein the etching process, which is performed using the second photoresist pattern as the etching barrier, includes a wet etching process.

16. The method as claimed in claim 10, wherein the organic anti-reflective layer and the hard mask layer are etched through a plasma dry etching process.

17. The method as claimed in claim 16, wherein the organic anti-reflective layer is etched by using oxygen-based gas.

18. The method as claimed in claim 16, wherein the hard mask layer is etched by using fluorine-based gas.

19. The method as claimed in claim 10, wherein the hard mask layer remaining in the logic region is removed through a wet etching process.
